# FASCICULE DE BREVET EUROPEEN

(11) **EP 3 844 807 B1**
(45) Date de publication et mention de la délivrance du brevet: **19.02.2025**
(21) Numéro de dépôt: 19779058.7
(22) Date de dépôt: 23.08.2019
(51) Int. Cl.: H01L 21/78, H01L 21/683

(54) **PROCÉDÉ DE SÉPARATION D'UNE PLAQUE EN COMPOSANTS INDIVIDUELS**
VERFAHREN ZUM TRENNEN EINER PLATTE IN EINZELNE BAUTEILE
PROCESS FOR SEPARATING A PLATE INTO INDIVIDUAL COMPONENTS

(30) Priorité: 27.08.2018 FR 1857666
(43) Date de publication de la demande: 07.07.2021
(73) Titulaire: MACOM Technology Solutions (France), 94450 Limeil-Brévannes (FR)
(72) Inventeur: FRIJLINK, Peter, 91330 YERRES (FR)
(74) Mandataire: Fédit-Loriot
(86) Numéro de dépôt international: PCT/FR2019/051955
(87) Numéro de publication internationale: WO 2020/043981

(56) Documents cités:
- WO-A1-2008/005979
- US-A1- 2008 003 780
- US-A1- 2010 233 867
- US-A1- 2016 035 616

## Description

L'invention concerne la séparation d'une plaque en une pluralité de composants individuels détachés, dite aussi singulation de puces (« chip singulation » en anglais) ou découpe de plaque en puces (« wafer dicing » en anglais). US 2008/003780, US 2010/233867, US 2016/035616 et WO 2008/005979 décrivent de tels procédés.

Classiquement, une plaque est fabriquée en déposant sur une galette (« wafer » en anglais) un empilement de couches de semi-conducteurs, de métal ou autre, par exemple une couche canal, une couche barrière, etc. Il est connu de structurer ces couches au moyen de lithographie, afin que les puces puissent remplir des fonctionnalités définis par des spécifications.

On prévoit ensuite des post-traitements (« back end process » en anglais).

Parmi des post-traitements, une étape de test peut permettre de repérer les éventuelles puces défectueuses, ou de classer les puces selon diverses spécifications. Les mesures effectuées pendant cette étape de test impliquent des contacts physiques avec la plaque.

Puis on procède à la singulation, c'est-à-dire que la plaque obtenue est découpée en plusieurs composants individuels.

Pour ce faire, on dépose la plaque sur un film de découpage (« dicing film » en anglais), flexible, élastique, étirable et collant, et l'ensemble est installé sur une table à vide équipée d'un système d'aspiration. L'aspiration via des orifices définis dans la table à vide maintient l'ensemble pendant le découpage proprement dit.

Le découpage peut être effectué par sciage, mais on connait aussi la découpe par rainurage et clivage, la découpe laser et la découpe par gravure.

Dans le cas d'une découpe laser, on peut éventuellement retirer des couches protectrices, et effectuer un nettoyage.

Dans le cas d'une découpe par sciage, on effectue un nettoyage à l'eau (« thorough water jet cleaning » en anglais).

Puis on détache les composants individuels du film de découpage.

La plaque peut avoir une épaisseur de l'ordre de 100 µm, mais cette épaisseur tend à diminuer avec la miniaturisation des composants et l'augmentation des fréquences des signaux électriques dans de nouveaux domaines d'application. On rencontre déjà des plaques de 25 ou 50 µm.

Or plus la plaque est mince, plus le risque de détériorer la plaque, voire de la rompre, augmente au cours de ces traitements postérieurs à la fabrication, ce qui impose davantage de contraintes, notamment en termes de manipulation.

En particulier, les mesures effectuées avant découpe et détachement risquent de ne plus être entièrement valables. Ceci peut mener à des pertes économiques et de fiabilité quand ces puces seront ensuite montées dans des sous-ensembles.

Il existe donc un besoin pour un procédé de séparation d'une plaque en composants individuels qui soit moins contraignant.

Il est proposé un procédé de post-traitement d'une plaque pour obtenir une pluralité de composants électriques, optiques ou optoélectroniques individuels détachés, comprenant
a) prévoir un substrat,
b) fixer la plaque au substrat au moyen d'une couche sacrificielle entre cette plaque et ce substrat, la couche sacrificielle étant réalisée en un (ou plusieurs) matériau(x) à l'état solide (avantageusement rigide) à température et pression ambiantes, et ayant une température de transformation vers un ou plusieurs composés gazeux à la pression ambiante comprise entre 80°C et 600°C,
c) séparer la plaque fixée sur le substrat en une pluralité de portions de plaque,
d) augmenter la température et/ou diminuer la pression environnante à une température suffisamment élevée et/ou à une pression suffisamment faible, respectivement, pour transformer en composé(s) gazeux la couche sacrificielle fixée à la pluralité de portions de plaque, la pluralité de portions de plaque reposant alors directement sur ledit substrat.

Au cours de l'étape c), la séparation de la plaque en une pluralité de portions de plaque peut être menée de façon à laisser le substrat d'une seule pièce. Dit autrement, la séparation n'affecte pas le substrat.

L'étape d) peut être menée alors que la pluralité de portions de plaque est fixée à un substrat d'une seule pièce (un seul substrat pour une pluralité de portions de plaque). La transformation en composé(s) gazeux de la couche sacrificielle laisse la pluralité de portions de plaque sur ce substrat.

Ainsi, plutôt qu'un film de découpage flexible, élastique, étirable et collant, on a recours à une couche sacrificielle relativement simple à éliminer, ce qui peut permettre de faciliter les traitements post-fabrication (par exemple des mesures, des étapes de découpage, des étapes de transport, etc.)

Avec le procédé décrit ci-dessus, l'élimination de la couche sacrificielle peut être relativement simple à mener, en ce sens qu'il suffit par exemple de chauffer à une température suffisante, le (ou les) matériau(x) de la couche sacrificielle s'éliminant alors de l'ensemble par transformation à un ou plusieurs composés à l'état gazeux.

De façon surprenante, une fois la couche sacrificielle transformée, les composants individuels peuvent adhérer légèrement au substrat, cette adhésion étant suffisamment élevée pour que l'ensemble substrat plus composants individuels puisse être transporté facilement, et en même temps suffisamment faible pour que chaque composant puisse être saisi et détaché du substrat sans risquer de le détériorer.

En outre, une fois la couche sacrificielle transformée, l'emplacement des composants est connu, et ce même si l'ensemble substrat plus composants a été transporté. Il n'est ainsi plus besoin d'avoir recours à des outils de reconnaissance de forme pour effectuer la saisie des composants.

Dans certains cas, on pourra alors même effectuer des mesures électriques sur les composants afin de les trier selon diverses spécifications, et les informations obtenues permettront ensuite le tri des puces lors du prélèvement, qui sera représentatif de l'état final des puces.

En outre, il peut ne plus rester trace de cette couche sacrificielle sur les composants. Dans la mesure où le ou les matériau(x) sacrificiel(s) utilisés se transforment complètement en un ou plusieurs composés gazeux par décomposition, sublimation ou vaporisation, quand, après la séparation en puces et les nettoyages éventuels associés, on élève la température au delà de la température de transformation, le nettoyage des puces individuelles détachées n'est plus nécessaire.

L'invention peut permettre en outre d'éviter l'étape d'illumination aux rayonnements ultra-violets qui est menée dans l'art antérieur pour réduire l'adhérence du film flexible et collant de découpage. Cette étape a lieu dans l'art antérieur postérieurement à la découpe, afin que l'adhérence reste élevée pendant la séparation, mais antérieurement à la saisie des composants, afin de faciliter le détachement du film flexible de découpage. Dans ce cas il reste dans l'art antérieur en pratique toujours une adhérence résiduelle, qui rend le détachement des puces minces et fragiles risqué, surtout quand il faut éviter de courber les puces pour ne pas endommager leurs structures. L'invention peut permettre de réduire l'adhérence des puces au substrat à une valeur beaucoup plus faible. Ceci peut être particulièrement intéressant pour des puces d'épaisseur inférieures à 100 µm, et quand les puces sont réalisées dans des matériaux qui se clivent facilement, comme par exemple GaAs ou InP.

Dans la mesure où l'ensemble formé par la couche sacrificielle et le substrat est plus rigide que le film de découpage de l'art antérieur, l'invention peut permettre de faire plus facilement sur une plaque très mince toutes les opérations technologiques classiques de fabrication, après amincissement, comme la lithographie, le dépôt de résines, l'exposition photo, le développement de la résine, les dépôts de couches de matériaux, les gravures, les délaquages, les nettoyages, avec un risque moindre de clivage de la plaque, étant entendu que la température lors de l'opération reste inférieure à la température de transformation du matériau sacrificiel. On pourra choisir le matériau sacrificiel qui a une température de transformation suffisamment élevée pour cela, dans la limite que les composants sur les puces ne doivent pas se dégrader pendant la transformation.

L'étape d) peut avantageusement être menée jusqu'à éliminer (par transformation) plus de 90% en masse du (ou des) matériau de la couche sacrificielle, avantageusement plus de 99%, avantageusement la totalité de cette couche sacrificielle.

Le substrat peut être flexible ou rigide.

Par exemple, dans le cas d'une plaque fixée à un substrat rigide, on pourra effectuer les étapes de test sur la plaque alors qu'elle est fixée au substrat via la couche sacrificielle. Le risque de dégradations liées aux mesures est donc moindre du fait de l'épaisseur de l'ensemble, et du choix d'un substrat d'une bonne solidité mécanique

Dans certains cas, on pourra effectuer les mesures électriques (permettant de classifier les puces) après la séparation, parce que les puces sont toujours fixées au substrat aux mêmes distances fixes qu'elles avaient avant la séparation. Les classements issus de ces mesures peuvent être plus fiables que dans l'art antérieur.

L'invention permet en outre de faciliter le transport de la plaque, car grâce à la rigidité apportée par le substrat, le risque de détérioration est moindre. L'invention peut permettre en particulier de facilement mettre en place des mesures sur des sites distants, car le transport est ainsi moins risqué, et ce de façon relativement simple.

L'invention peut ainsi permettre d'améliorer significativement le rendement.

Avantageusement, une fois la plaque fixée au substrat, toutes les étapes précédant l'étape c) de séparation sont effectuées dans des conditions de température et de pression telles que la couche sacrificielle reste solide.

Des opérations comme le transport, les mesures, des découpes mécaniques, etc. peuvent être menées à température et pression ambiante, c'est-à-dire que la couche sacrificielle est alors solide.

Le procédé de post-traitement peut ainsi avantageusement comprendre au moins une étape de traitement menée à température et pression ambiantes, par exemple une étape de mesure, une étape de transport, une étape de polissage, une étape de découpe mécanique, ou autre.

D'autres opérations comme la découpe laser ou autre peuvent impliquer une augmentation (éventuellement locale) de la température et/ou de la pression. On pourra veiller à rester alors dans des conditions de température et de pression telles que la couche sacrificielle reste solide.

Pour éliminer la couche sacrificielle, on pourra élever la température à la température de transformation en un ou plusieurs composés gazeux, ou à une température supérieure.

Bien entendu, si l'étape d'élimination de la couche sacrificielle est menée sous une pression différente de la pression ambiante, on pourra adapter la température afin de s'assurer de l'élimination de la couche sacrificielle, notamment dans le cas d'une transformation par sublimation ou vaporisation.

L'augmentation de la température peut ainsi être menée conjointement avec une diminution de la pression environnante.

On peut alternativement se contenter de faire le vide, sans augmenter la température, pour éliminer la couche sacrificielle, notamment si la température environnante est déjà élevée.

Avantageusement, lors de l'étape d), la température est augmentée à une température entre 80°C et 600°C, avantageusement une température supérieure à 100°C, avantageusement à 150°C, avantageusement à 200°C.

Cette température peut avantageusement être inférieure à 500°C, avantageusement être inférieure à 400°C, avantageusement être inférieure à 350°C.

Avantageusement, cette température peut être dans une plage entre 230°C et 350°C.

La plaque et le substrat peuvent être choisis de façon à rester à l'état solide lorsque la température est augmentée.

Le substrat pourra avantageusement être réutilisé.

La couche sacrificielle peut, à pression ambiante, être transformée en un ou plusieurs composés gazeux à une température comprise entre 80°C et 600°C, avantageusement entre 230°C et 350°C.

Avantageusement et de façon non limitative, la couche sacrificielle a une température de transformation en un ou plusieurs composés gazeux, à pression ambiante, supérieure à 100°C, avantageusement à 150°C, avantageusement à 200°C.

Avantageusement et de façon non limitative, la couche sacrificielle a une température de transformation en un ou plusieurs composés gazeux, à pression ambiante, inférieure à 500°C, avantageusement inférieure à 400°C, avantageusement inférieure à 350°C.

Avantageusement, cette température de transformation en un ou plusieurs composés gazeux, à pression ambiante, peut être dans une plage entre 230°C et 350°C.

La pression ambiante peut être comprise entre 50 kPa et 105 kPa, avantageusement entre 80 kPa et 105 kPa, par exemple égale à 101 kPa.

La température ambiante peut être comprise entre 0°C et 50°C, avantageusement entre 15°C et 35°C, par exemple entre 20°C et 25°C.

Par « transformation vers un ou plusieurs composés gazeux », on entend aussi bien une décomposition en un ou plusieurs composés gazeux qu'une évaporation ou une sublimation.

Par « température de décomposition », on entend la température conduisant à la décomposition de la moitié du matériau en une heure.

Le substrat peut être un substrat de saphir, de silicium, en verre, en métal ou autre.

Le substrat peut avoir une épaisseur inférieure au millimètre, ou non.

Il est judicieux de choisir pour le substrat un (ou plusieurs) matériau(x) résistant à la température de transformation en un ou plusieurs composés gazeux de la couche sacrificielle.

La plaque peut être rigide, ou bien alternativement flexible. Dans ce dernier cas, la plaque et le substrat (par exemple un substrat en métal) peuvent par exemple être enroulés en un rouleau. Ce rouleau peut avoir un diamètre de profil de l'ordre de 60 cm par exemple.

Dans le cas d'une plaque flexible, on pourra privilégier une découpe laser pour effectuer l'étape c) de séparation.

La plaque peut avoir une épaisseur inférieure au millimètre, typiquement inférieure à 200 µm, avantageusement inférieure ou égale à 100 µm.

La plaque peut comprendre des matériaux cristallins, semi-cristallins ou amorphes, par exemple un matériau semi-conducteur, du métal, un matériau diélectrique, du verre, un matériau céramique, un polymère, ou autre, une combinaison de ces matériaux, par exemple en couches, un mélange de ces matériaux, ou autre.

Dans le cas d'une plaque de semi-conducteur, la plaque peut par exemple comprendre essentiellement (c'est-à-dire à plus de 80% en masse) du silicium Si, du germanium Ge, de l'arséniure de gallium GaAs, de l'arséniure d'indium InAs, du phosphure d'indium InP, du phosphure de gallium GaP, de l'antimoniure de gallium GaSb, de l'antimoniure d'indium InSb, du carbure de silicium SiC, du nitrure de gallium GaN, du nitrure d'aluminium AlN, et/ou du diamant. Ces matériaux peuvent être combinés en couches, mélangés, ou autre.

La galette dont est issue la plaque peut comprendre essentiellement un ou plusieurs de ces matériaux.

Ces matériaux peuvent être dopés, ou non.

Dans un mode de réalisation, on peut prévoir de creuser des rainures sur une face de la plaque préalablement à la fixation de la plaque au substrat. La profondeur de ces rainures n'atteint pas la face opposée de la plaque.

On peut prévoir une profondeur de rainure égale ou légèrement supérieure à l'épaisseur souhaitée pour les puces lorsqu'elles seront détachées.

Cette étape de formation de rainures peut par exemple être menée par gravure, par exemple gravure plasma, par laser, et/ou de façon mécanique, par exemple au moyen d'une lame de scie.

Cette étape de formation de rainure peut être relativement facile à mener dans la mesure où la plaque peut à ce stade présenter une épaisseur relativement élevée, par exemple de l'ordre de 600 µm ou 800 µm.

La plaque rainurée peut ensuite être fixée via la couche sacrificielle au substrat (étape b)).

Avantageusement et de façon non limitative, cette fixation peut être effectuée avec la face rainurée du côté du substrat, c'est-à-dire que la face définissant les rainures est alors côté substrat.

On peut prévoir qu'à l'étape c), on creuse alors légèrement la plaque aux emplacements des rainures, par exemple jusqu'à atteindre les rainures ou bien de façon à permettre un clivage aisé, pour séparer la plaque en portions de plaque.

Mais avantageusement, lors de l'étape c) de séparation, on peut amincir la plaque par la face opposée à la face rainurée. Cet amincissement peut par exemple être obtenu par rodage, au moyen d'une meule, par polissage, par attaque chimique, ou autre.

Dans un mode de réalisation avantageux, on amincit la plaque jusqu'à atteindre les rainures, de sorte que l'amincissement aboutit en une séparation de la plaque en plusieurs portions de plaque.

Alternativement, l'amincissement peut être stoppé alors que les rainures ne sont pas atteintes, notamment dans le cas d'une séparation ultérieure par clivage. On peut aussi prévoir que la séparation soit obtenue en effectuant des découpes sur la plaque amincie fixée au substrat, par exemple au moyen de laser, gravure, ou autre. Ces découpes pourront être relativement peu profondes.

Avantageusement, avant détachement, alors que les puces sont encore fixées au substrat par la couche sacrificielle, on peut prévoir une ou des étapes de traitement, par exemple pour ajouter des composants, effectuer des masquages, des gravures de trous (« via-holes » en anglais), etc. Lorsque le substrat est rigide, ces étapes de traitement peuvent être relativement simples à mener car les emplacements et les alignements sont relativement bien maitrisés. Ces étapes de traitement peuvent intervenir avant ou après l'étape de séparation.

Avantageusement, l'étape c) de séparation peut comprendre une étape de découpe de la plaque fixée au substrat avec la couche sacrificielle, notamment lorsque la plaque n'a pas été rainurée.

Dans un mode de réalisation, la découpe de la plaque en puces peut être menée (ou induite, c'est-à-dire que la découpe est suivie d'un clivage) de façon mécanique, par exemple au moyen d'une lame de scie, notamment dans le cas d'une plaque rigide. Du fait du maintien apporté par la couche sacrificielle et le substrat, le risque de rupture ou de détérioration lié à la découpe est moindre que dans l'art antérieur, dans lequel la plaque mince repose sur un film flexible, élastique et étirable.

Une lame, d'une scie circulaire par exemple, peut être disposée de sorte que la profondeur de la découpe atteigne le substrat, notamment dans le cas d'un substrat de silicium.

Alternativement, la lame peut être disposée de façon à atteindre la couche sacrificielle seulement, notamment dans le cas d'un substrat de saphir.

On peut former une rainure par exemple avec un diamant, et prévoir ensuite un clivage.

Dans un mode de réalisation, la découpe peut être réalisée par gravure.

On pourra par exemple recouvrir la plaque d'un (ou plusieurs) matériau(x) de masquage dans lequel on définit des ouvertures correspondant aux futurs contours des composants.

Pour masquer, on pourra par exemple utiliser une simple couche de résine photosensible.

Dans le cas où une résine ne résiste pas suffisamment à la gravure des matériaux de la plaque, on pourra utiliser une couche d'un matériau qui résiste à la gravure, comme par exemple un matériau diélectrique comme par exemple de l'oxyde de silicium ou nitrure de silicium, ou un métal comme par exemple le nickel. Les ouvertures dans ce matériau qui délimitent les puces peuvent être obtenues par photolithographie avec les moyens classiques connus de l'homme du métier.

On pourra prévoir une étape de retrait du ou des matériaux de masquage, avantageusement préalablement à l'augmentation de température amenant l'élimination de la couche sacrificielle.

On pourra prévoir une gravure chimique humide, une photolithogravure, ou autre.

Avantageusement, la découpe peut être menée au moyen d'une gravure plasma. L'invention permet d'éviter les contraintes imposées par le film flexible de découpage (« dicing film »). En effet, la plupart de ces films flexibles sont réalisés dans des matériaux se dégradent lorsque la température s'élève au-dessus de 100°C ou de 150°C, c'est-à-dire à des températures facilement atteintes lors de l'application d'un plasma.

En particulier, dans le cas d'une plaque réalisée à partir d'une galette de SiC, cette plaque peut atteindre des températures plus hautes encore lors de l'application d'un plasma, ce qui dans l'art antérieur interdit ce type de découpe pour ce type de plaque. D'autant plus que des parties du film flexible de découpage seraient alors directement explosées au plasma. L'invention peut ainsi permettre ainsi de réaliser une séparation par découpe plasma d'une plaque issue d'une galette de SiC.

Dans un autre mode de réalisation, on pourra effectuer plusieurs gravures successives, notamment dans le cas d'une plaque comprenant un empilement de couches. Chaque gravure peut correspondre à une ou plusieurs couches.

Dans un autre mode de réalisation, la découpe pout être menée ou induite au moyen d'un laser. Là encore, l'invention peut permettre de limiter les tensions et les déformations des bords des composants notamment dans le cas d'un film sacrificiel rigide.

On pourra par exemple combiner laser et clivage (découpe induite).

Dans un mode de réalisation, la découpe peut être menée ou induite en combinant gravure(s), découpe laser et/ou découpe mécanique.

Dans un mode de réalisation, l'étape d) d'augmentation de la température pour éliminer la couche sacrificielle peut s'accompagner d'une diminution de la pression, par exemple à 1000 Pa ou moins, afin de faciliter cette élimination.

Le procédé peut comprendre en outre une étape de saisie des composants ainsi obtenus, par exemple au moyen d'un outil de prise à vide en caoutchouc (« rubber vacuum tool » en anglais).

L'invention permet d'effectuer cette saisie sans créer de tensions relativement élevées, limitant là encore le risque de détérioration des composants. Les procédés connus de l'art antérieur, impliquant une saisie d'un composant reposant sur un film flexible et en général relativement adhésif, sont susceptibles de conduire à des détériorations parfois non détectables optiquement, mais qui peuvent affecter le fonctionnement des capacités et transistors intégrés dans le composant.

Dans un mode de réalisation, la couche sacrificielle peut être à base de polymères, c'est-à-dire comprendre au moins 50%, avantageusement au moins 70% ou 90% en masse de polymères bruts, avantageusement entre 99% et 100% en masse de polymères bruts.

Ces polymères bruts peuvent avantageusement être constitués, par exemple à plus de à plus de 70% en masse, avantageusement à plus de 90% en masse, avantageusement entre 99% et 100% en masse, de molécules de polypropylène carbonate, d'autres polycarbonates et/ou de molécules de polynorbornène.

Dans ce cas, il s'agit de polymères se décomposant à une température entre 80°C et 600°C, et qui lors de cette décomposition se transforment entièrement en composés gazeux, sans résidus.

Dans un autre mode de réalisation, on peut utiliser comme matériau sacrificiel un matériau comme l'anthracène ou le camphre, que l'on pourra éliminer par sublimation en élevant la température sous pression réduite, sans résidus.

On pourra relever que la plaque peut être fixée côté face arrière (« backside » en anglais) au substrat via la couche sacrificielle, ou bien encore sur son autre face (« front side » en anglais). Une fixation côté face arrière peut présenter l'avantage de faciliter l'accès aux composants en face avant, notamment lors des étapes de test.

Dans un mode de réalisation, la fixation de la plaque au substrat via la couche sacrificielle peut être menée à une température supérieure à une température de transition vitreuse du (ou des) matériau(x) de la couche sacrificielle, avantageusement en appliquant une force de pression uniaxiale normale à la plaque (par exemple de 10 ou 30 N/cm²) et/ou sous une pression environnante inférieure à 50 kPa, avantageusement sous un vide poussé. On peut ainsi réaliser un collage moléculaire (« molecular attachment » en anglais), c'est-à-dire que des forces électrostatiques comme les forces de Van der Waals participent à la fixation. Ceci peut être particulièrement intéressant dans le cas d'un matériau de couche sacrificielle relativement peu adhésif.

Dans la présente demande, on entend par « sur » aussi bien « directement sur » qu' « indirectement sur », c'est-à-dire qu'une couche déposée sur une autre peut être en contact avec cette autre couche, ou bien séparée de cette autre couche par une ou plusieurs couches intermédiaires.

On peut prévoir une ou plusieurs couches sacrificielles, pourvu que le jeu d'au moins une couche soit en contact avec la plaque et avec le substrat. Dit autrement, la couche sacrificielle en contact avec la plaque et le substrat, et dont la transformation à l'état gazeux peut amener les portions de plaque à adhérer légèrement au substrat peut comprendre plusieurs sous-couches, par exemple une première sous-couche en un premier matériau directement sur le substrat et une deuxième sous-couche en un deuxième matériau distinct du premier matériau, entre la première sous-couche et la plaque, et en contact avec la première sous-couche et la plaque.

Ceci peut se reformuler en énonçant que la plaque est fixée au substrat par un jeu d'au moins une couche sacrificielle, en contact avec la plaque et avec le substrat et que c'est ce jeu qui est réalisé en matériau(x) à l'état solide (avantageusement rigide) à température et pression ambiantes, et ayant une température de transformation vers un ou plusieurs composés gazeux à la pression ambiante comprise entre 80°C et 600°C, et que c'est ce jeu d'au moins une couche qui est ensuite transformé en un ou plusieurs composés gazeux.

Le ou les matériau(x) entre la plaque séparée en portions de plaque et le substrat ayant été transformés en composé(s) gazeux, ces portions de plaque sont alors directement sur le substrat, et, de façon étonnante, peuvent adhérer légèrement au substrat.

L'invention n'est en rien limitée par la façon dont la couche sacrificielle est appliquée sur le substrat. On pourra par exemple prévoir de mélanger le ou les matériaux de la couche sacrificielle à un solvant, afin d'obtenir un liquide que l'on dépose sur le substrat. Le solvant s'évapore ensuite, laissant en place le ou les matériaux de la couche sacrificielle. On pourra s'aider par une tournette afin d'obtenir une couche d'épaisseur égale sur toute la surface, tel que utilisée pour l'épandage des résines photosensibles sur les plaques dans l'industrie des semiconducteurs.

Avantageusement, le substrat peut présenter un coefficient de dilatation latérale égal ou proche (différence relative de moins de 5%) du coefficient de dilatation latérale de la plaque. Ainsi, lors de l'augmentation de température que nécessitent diverses opérations technologiques et lors de l'augmentation de température effectuée en vue d'éliminer la couche sacrificielle et/ou lors d'une augmentation de température au cours de mesures, on évite de créer des tensions sur la plaque, qui pourraient la cliver, ou qui pourraient amener à une délamination précoce de l'ensemble substrat- couche sacrificielle - plaque.

L'invention sera mieux comprise en référence aux figures, lesquelles illustrent des modes de réalisation donnés à titre d'exemple et non limitatifs.
Les figures 1 à 6 sont des vues en coupe, et très schématiques, illustrant un exemple de procédé selon un mode de réalisation de l'invention.
Les figures 7 à 11 sont des vues en coupe, et très schématiques, illustrant un exemple de procédé selon un autre mode de réalisation de l'invention.

Des références identiques seront utilisées d'une figure à l'autre pour désigner des éléments identiques ou similaires.

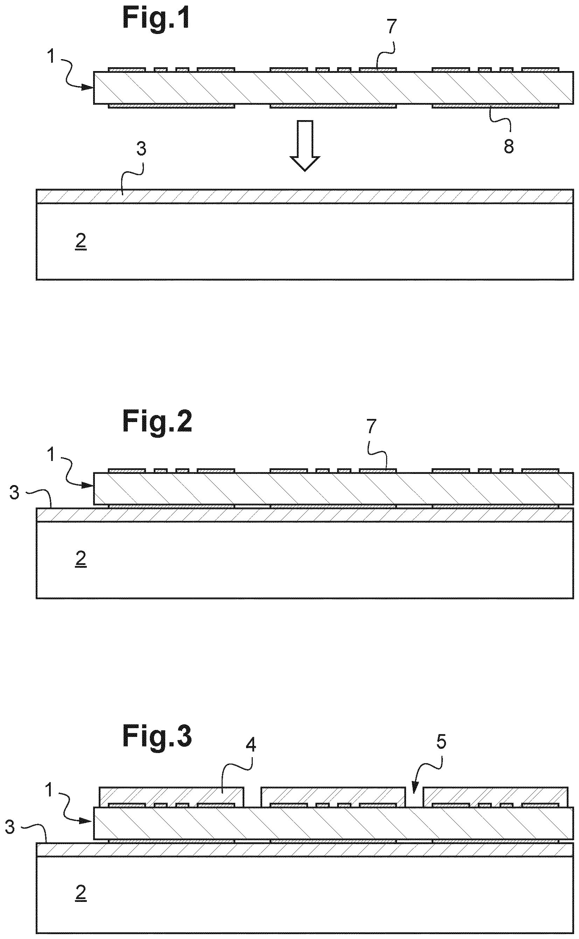

En référence à la figure 1, on prévoit un substrat 2 rigide, par exemple un substrat de saphir.

Ce substrat 2 est recouvert d'une couche sacrificielle 3.

Cette couche sacrificielle est composée à plus de 99% en masse de molécules de polymères, par exemple de molécules de polypropylène carbonate.

Ce matériau polymère 3 peut par exemple être appliqué sur le substrat par les mêmes méthodes habituelles d'application d'une résine photosensible.

Le polymère peut être appliqué en solution dans un solvant, ce solvant s'évaporant rapidement après l'application.

On peut terminer l'évaporation du solvant par un recuit à une température inférieure à la température de décomposition du polypropylène carbonate.

On dépose sur ce matériau polymère 3 une plaque 1, que l'on fixe solidement en appliquant une pression mécanique perpendiculaire à la plaque, à une température au delà de la température de transition vitreuse du matériau sacrificiel.

Comme illustré sur les figures, cette plaque peut comprendre des interconnexions 7 et une couche de métallisation 8 (plan de masse).

Le matériau de la couche 3, solide, assure la fixation de la plaque 1 au substrat 2, comme illustré par la figure 2.

La plaque 1 a été obtenue à partir d'une galette, par exemple de GaAs, sur laquelle on a déposé de façon connue en soi les éléments constituant un circuit intégré de semi-conducteurs, comme une couche barrière, une couche canal, des drains, des sources, etc. non représentés ici.

Dans cet exemple, la plaque 1 est en contact avec la couche sacrificielle 3 par sa face arrière (« backside » en anglais).

Dans cet exemple, la plaque 1 peut par exemple avoir une épaisseur de l'ordre de 50 µm, et être destinée à être utilisée à des composants qui traitent des signaux avec des fréquences de 300 GHz, qui nécessitent que l'épaisseur ne soit pas plus élevée, pour éviter des modes de transmission parasites à l'intérieur de la puce.

En référence à la figure 2, laquelle représente la plaque 1 fixée au substrat 2 avant découpe, on peut procéder relativement facilement à des opérations de transport, de mesure au moyen de sonde, car l'épaisseur du substrat 2 vient pallier à la faible épaisseur de la plaque 1 et apporte la tenue mécanique nécessaire pour limiter considérablement le risque d'endommagement.

Ces mesures peuvent parfois s'accompagner de hausses de température, dans des conditions telles que la couche sacrificielle reste intacte, auquel cas il est judicieux de choisir un substrat ayant un coefficient de dilation proche de celui de la plaque. Dans cet exemple, le substrat est un substrat de saphir et la plaque de type GaAs, mais on pourrait prévoir un substrat réalisé dans le même matériau que celui de la galette dont est issue la plaque.

En référence à la figure 3, pour préparer l'étape de découpe, on dépose du matériau photorésistant 4 de façon à définir des ouvertures rectilignes 5, correspondant aux futures découpes.

Classiquement, on prévoira des ouvertures rectilignes s'étendant perpendiculairement au plan du dessin, comme celles 5 visibles sur la figure, et d'autres ouvertures rectilignes parallèles entre elles et croisant les ouvertures rectilignes s'étendant perpendiculairement au plan de la feuille.

Avec les méthodes de découpe par gravure ou par laser, ces ouvertures ne sont pas obligatoirement rectilignes.

Ce quadrillage de découpes peut ainsi définir des milliers de futurs composants sur une même plaque.

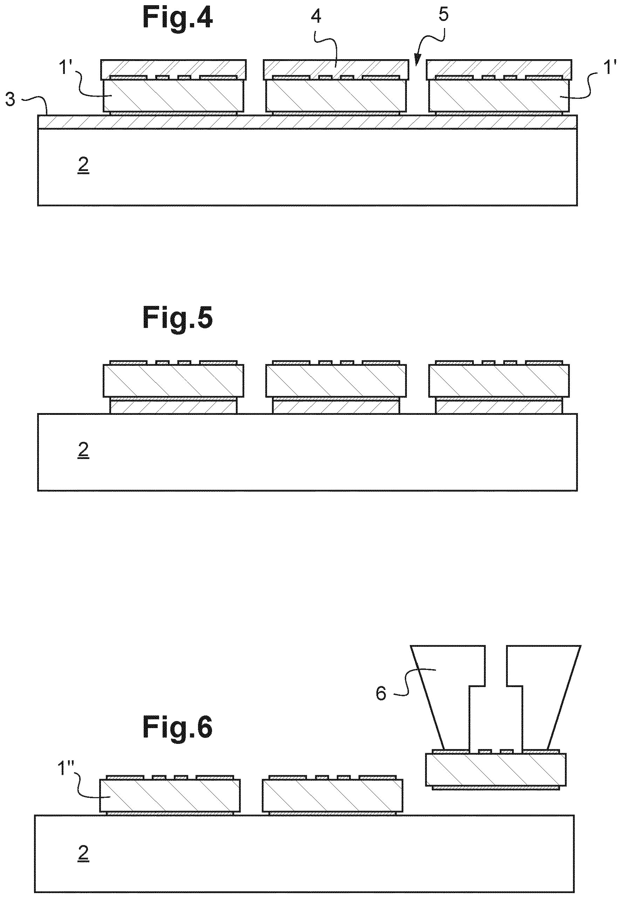

Puis on applique un plasma, de façon à graver la plaque 1 aux emplacements des découpes 5, comme illustré par la figure 4. On pourra avoir recours à une gravure de type RIE (pour « Reactive Ion Etching ») en anglais).

La plaque 1 est alors découpée en une pluralité de portions de plaque 1' correspondant chacune à un composant individuel. Dans cet exemple, ces portions 1' reposent sur une même couche sacrificielle 3.

Le substrat n'est en revanche pas découpé et reste d'une seule pièce.

On peut ensuite appliquer un deuxième plasma, de dioxygène, pour retirer le masque 4 et creuser la couche sacrificielle aux emplacements définis par les ouvertures 5, comme illustré par la figure 5.

Puis on augmente la température, à 270°C par exemple, de sorte que les polymères de la couche sacrificielle 3 se décomposent et s'évaporent, comme illustré sur la figure 6.

Les composants 1' adhérent alors au substrat 2 par des forces relativement faibles (probablement de Van der Waals), permettant ainsi de déplacer l'ensemble tout en conservant les positions des composants 1" sur le substrat.

Un outil 6 réalisant une légère aspiration à vide peut permettre de facilement détacher les composants 1' du substrat 2.

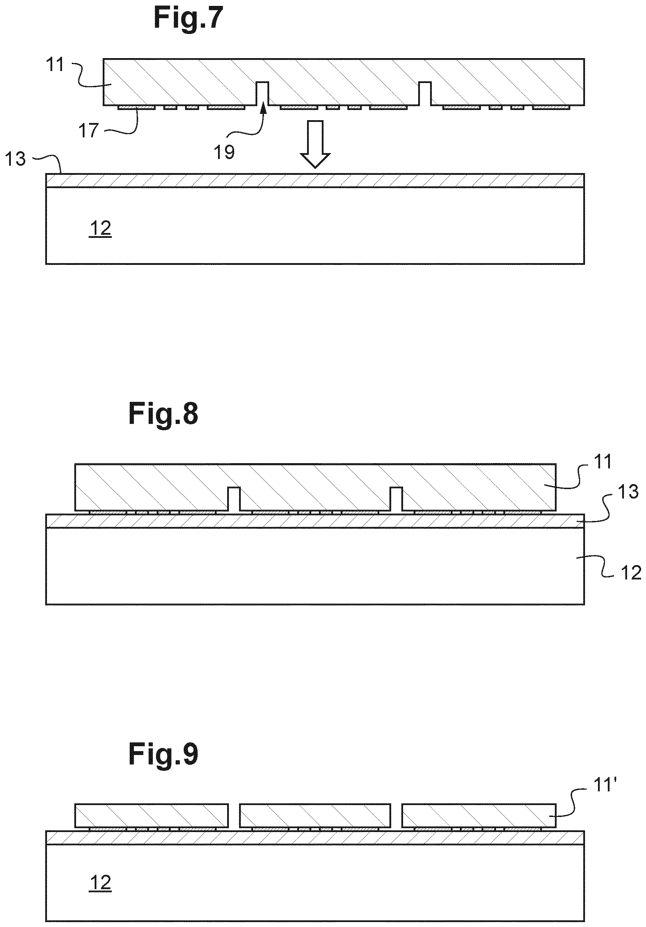

Dans le mode de réalisation des figures 7 à 11, on commence par définir des rainures 19 sur par exemple une face avant d'une plaque épaisse 11.

Sur cette face avant, on a déjà obtenu des interconnexions 17 par des procédés de type connus de l'art antérieur, qui symbolisent la présence d'un circuit intégré

Ces rainures 19 peuvent être creusées par des procédés connus en soi, par exemple par gravure, par laser, ou par des moyens mécaniques.

Les emplacements des rainures correspondent aux bords des futures puces.

Ces rainures seront creusées plus profondes que l'épaisseur finale des puces.

Ensuite, comme illustré sur les figures 7 et 8, on attache la plaque 11 côté face avant sur un substrat 12 par l'intermédiaire d'une couche sacrificielle 13.

On pourra éventuellement creuser alors des trous à travers le substrat 12.

Puis on amincit la plaque 11 à l'épaisseur finale des puces, ce qui a pour effet de séparer les puces. On peut par exemple polir la plaque 11 jusqu'à atteindre les rainures 19.

Les portions de plaque 11' peuvent alors présenter une épaisseur de l'ordre de 50 µm ou 100 µm.

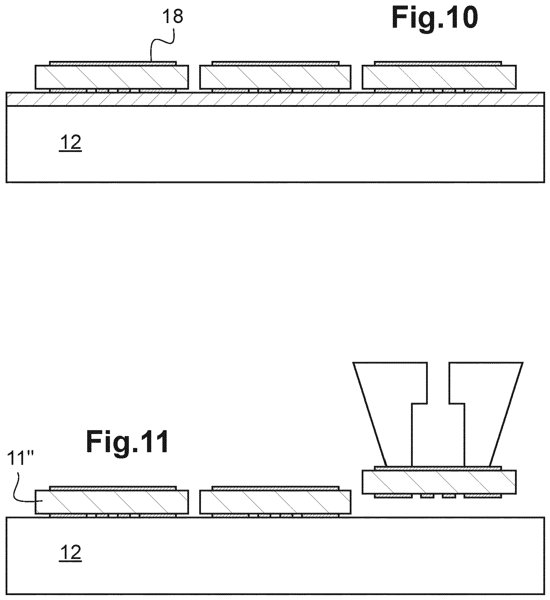

Après un nettoyage et d'éventuelles étapes technologiques comme le creusement de trous ( en anglais « via-holes » ) à travers les puces et la métallisation de la face arrière des puces (voir la référence 18 sur la figure 10), on effectue un recuit à la température de la transformation de la couche sacrificielle (ou au-dessus), pour détacher les puces du substrat.

Comme illustré sur la figure 11, la couche sacrificielle a alors disparu, et les puces 11" adhérent légèrement au substrat 12.

Dans un mode de réalisation alternatif et non représenté, on peut graver des trous (« via-holes » en anglais) préalablement à l'étape d'amincissement. Il sera alors judicieux de procéder à un nettoyage des trous une fois l'amincissement effectué.

Dans un mode de réalisation alternatif et non représenté, la plaque peut être rainurée sur sa face arrière et fixée au substrat par sa face arrière. Une fois amincie, on peut effectuer divers traitements, par exemple dépôt de couches, gravures, etc., et ce d'autant plus facilement que le substrat est rigide car on maîtrise alors les alignements.

## Revendications

1. Procédé de post-traitement d'une plaque (1) pour obtenir une pluralité de composants électriques, optiques ou optoélectroniques individuels détachés (1"), comprenant
a) prévoir un substrat (2),
b) fixer la plaque au substrat au moyen d'une couche sacrificielle (3) entre cette plaque et ce substrat, la couche sacrificielle étant en contact avec la plaque et avec le substrat, la couche sacrificielle étant réalisée dans au moins un matériau à l'état solide à température et pression ambiantes, la couche sacrificielle ayant une température de transformation en un ou plusieurs composés gazeux à pression ambiante comprise entre 80°C et 600°C,
c) séparer la plaque fixée sur le substrat en une pluralité de portions de plaque fixées sur le substrat, le substrat restant d'une seule pièce, et
d) augmenter la température et/ou diminuer la pression environnante à une température suffisamment élevée et/ou à une pression suffisamment faible, respectivement, pour transformer en composé(s) gazeux la couche sacrificielle fixée à la pluralité de portions de plaque, la pluralité de portions de plaque reposant alors directement sur ledit substrat.

2. Procédé selon la revendication 1, dans lequel l'étape c) de séparation comprend une étape de découpe de la plaque (1) fixée au substrat (2) par la couche sacrificielle (3).

3. Procédé selon la revendication 2, dans lequel la plaque (1) est découpée par gravure.

4. Procédé selon la revendication 3, dans lequel la gravure est une gravure plasma.

5. Procédé selon l'une quelconque des revendications 2 à 4, dans lequel la découpe est menée ou induite au moyen d'un laser.

6. Procédé selon l'une quelconque des revendications 2 à 5, dans lequel la découpe est menée ou induite de façon mécanique, par exemple au moyen d'une lame de scie.

7. Procédé selon l'une quelconque des revendications 1 à 6, dans lequel,
préalablement à l'étape b) de fixation de la plaque (11) au substrat, on creuse des rainures (19) sur une face, dite face rainurée, de la plaque, lesdites rainures n'atteignant pas la face de la plaque opposée à ladite face rainurée,
lors de l'étape de b) fixation, ladite face rainurée est en contact avec la couche sacrificielle (13),
lors de l'étape c) de séparation, on amincit la plaque par la face opposée à ladite face rainurée au moins jusqu'à atteindre les rainures.

8. Procédé selon l'une quelconque des revendications 1 à 7, dans lequel la couche sacrificielle (3 ;13) comprend au moins 70% en masse de polymères brut.

9. Procédé selon la revendication 8, dans lequel lesdits polymères bruts sont constitués à plus de 70% en masse de de molécules de polypropylène carbonate, d'autres polycarbonates et/ou de molécules de polynorbornène.

10. Procédé selon l'une quelconque des revendications 1 à 9, dans lequel la plaque (1 ;11) est obtenue à partir d'une galette comprenant essentiellement du silicium Si, du germanium Ge, de l'arséniure de gallium GaAs, de l'arséniure d'indium InAs, du phosphure d'indium InP, du phosphure de gallium GaP, de l'antimoniure de gallium GaSb, de l'antimoniure d'indium InSb, du carbure de silicium SiC, du nitrure de gallium GaN, du nitrure d'aluminium AlN, et/ou du diamant.

11. Procédé selon l'une quelconque des revendications 1 à 10, dans lequel la couche sacrificielle(3 ;13) a une température de passage à un état gazeux sous 100 kPa comprise entre 80°C et 600°C, avantageusement comprise entre 230°C et 350°C.

12. Procédé selon l'une quelconque des revendications 1 à 11, dans lequel la fixation de la plaque (1 ;11) au substrat (2 ;12) via la couche sacrificielle (3 ;13) est menée à une température supérieure à une température de transition vitreuse du (ou des) matériau(x) de la couche sacrificielle.

13. Procédé selon l'une quelconque des revendications 1 à 12, dans lequel la plaque (1 ;11) et le substrat (3 ;13) présentent des coefficients de dilatation égaux ou variant de moins de 5%.

## Patentansprüche

1. Verfahren zur Nachbehandlung einer Platte (1), um eine Vielzahl von freistehenden (1") einzelnen elektrischen, optischen oder optoelektronischen Komponenten zu erhalten, umfassend
a) Vorsehen eines Substrats (2),
b) Befestigen der Platte am Substrat mittels einer Opferschicht (3) zwischen der Platte und dem Substrat, wobei die Opferschicht mit der Platte und dem Substrat in Kontakt steht, wobei die Opferschicht aus mindestens einem Material hergestellt ist, das bei Umgebungstemperatur und -druck im festen Zustand vorliegt, wobei die Opferschicht eine Umwandlungstemperatur in eine oder mehrere gasförmige Verbindungen bei Umgebungsdruck zwischen 80 °C und 600 °C aufweist,
c) Trennen der am Substrat befestigten Platte in eine Vielzahl von am Substrat befestigten Plattenabschnitten, wobei das Substrat in einem Stück zurückbleibt, und
d) Erhöhen der Temperatur und/oder Verringern des Umgebungsdrucks bei je einer ausreichend hohen Temperatur und/oder einem ausreichend niedrigen Druck, um die an die Vielzahl von Plattenabschnitten befestigte Opferschicht in die gasförmige(n) Verbindung(en) umzuwandeln, wobei die Vielzahl von Plattenabschnitten dann direkt auf dem Substrat aufliegt.

2. Verfahren nach Anspruch 1, wobei der Schritt c) des Trennens einen Schritt des Ausschneidens der Platte (1) umfasst, die durch die Opferschicht (3) am Substrat (2) befestigt ist.

3. Verfahren nach Anspruch 2, wobei die Platte (1) durch Ätzen ausgeschnitten wird.

4. Verfahren nach Anspruch 3, wobei das Ätzen ein Plasmaätzen ist.

5. Verfahren nach einem der Ansprüche 2 bis 4, wobei das Ausschneiden mittels eines Lasers vorgenommen oder induziert wird.

6. Verfahren nach einem der Ansprüche 2 bis 5, wobei das Ausschneiden mechanisch, beispielsweise mittels eines Sägeblattes, vorgenommen oder induziert wird.

7. Verfahren nach einem der Ansprüche 1 bis 6, wobei vor dem Schritt b) des Befestigens der Platte (11) am Substrat Nuten (19) auf einer Seite, der sogenannten genuteten Seite, aus der Platte ausgehöhlt werden, wobei die Nuten nicht die Seite der Platte erreichen, die der genuteten Seite gegenüberliegen,
beim Schritt b) des Befestigens die genutete Seite mit der Opferschicht (13) in Kontakt ist,
beim Schritt c) des Trennens die Platte von der Seite, die der genuteten Seite gegenüberliegt, mindestens bis zum Erreichen der Nuten dünner gemacht wird.

8. Verfahren nach einem der Ansprüche 1 bis 7, wobei die Opferschicht (3; 13) mindestens 70 Masse-% Rohpolymere umfasst.

9. Verfahren nach Anspruch 8, wobei die Rohpolymere zu mehr als 70 Masse-% aus Polypropylencarbonat-Molekülen, anderen Polycarbonaten und/oder Polynorbornol-Molekülen bestehen.

10. Verfahren nach einem der Ansprüche 1 bis 9, wobei die Platte (1; 11) aus einem Wafer gewonnen wird, der im Wesentlichen Silizium Si, Germanium Ge, Galliumarsenid GaAs, Indiumarsenid InAs, Indiumphosphid InP, Galliumphosphid GaP, Galliumantimonid GaSb, Indiumantimonid InSb, Siliziumcarbid SiC, Galliumnitrid GaN, Aluminiumnitrid AlN und/oder Diamant umfasst.

11. Verfahren nach einem der Ansprüche 1 bis 10, wobei die Opferschicht (3; 13) eine Übergangstemperatur in einen gasförmigen Zustand unter 100 kPa zwischen 80 °C und 600 °C, vorteilhafterweise zwischen 230 °C und 350 °C, aufweist.

12. Verfahren nach einem der Ansprüche 1 bis 11, wobei das Befestigen der Platte (1; 11) am Substrat (2; 12) über die Opferschicht (3; 13) bei einer Temperatur vorgenommen wird, die über einer Glasübergangstemperatur des oder der Materialien der Opferschicht liegt.

13. Verfahren nach einem der Ansprüche 1 bis 12, wobei die Platte (1; 11) und das Substrat (3; 13) Ausdehnungskoeffizienten aufweisen, die gleich sind oder sich um weniger als 5% unterscheiden.

## Claims

1. Process for back end processing of a plate (1) in order to obtain a plurality of individual detached electrical, optical or optoelectronic components (1''), comprising:
a) providing a substrate (2),
b) attaching the plate to the substrate by means of a sacrificial layer (3) between this plate and this substrate, the sacrificial layer being in contact with the plate and with the substrate, the sacrificial layer being made from at least one material that is in a solid state at ambient temperature and ambient pressure, the sacrificial layer having a transformation temperature into one or more gaseous compounds at ambient pressure of between 80°C and 600°C,
c) separating the plate attached on the substrate into a plurality of plate portions attached on the substrate, the substrate remaining as a single piece, and
d) increasing the temperature and/or reducing the surrounding pressure to a sufficiently high temperature and/or a sufficiently low pressure, respectively, in order to transform the sacrificial layer attached to the plurality of plate portions into one or more gaseous compounds, the plurality of plate portions resting then directly on said substrate.

2. Process according to claim 1, wherein separation step c) comprises a step of dicing the plate (1) attached to the substrate (2) by the sacrificial layer (3).

3. Process according to claim 2, wherein the plate (1) is diced by etching.

4. Process according to claim 3, wherein the etching is plasma etching.

5. Process according to any one of claims 2 to 4, wherein the dicing is carried out or induced by means of a laser.

6. Process according to any one of claims 2 to 5, wherein the dicing is carried out or induced mechanically, for example by means of a saw blade.

7. Process according to any one of claims 1 to 6, wherein,
prior to step b) of attaching the plates (11) to the substrate, grooves (19) are hollowed out on one face, referred to as the grooved face, of the plate, said grooves not reaching the face of the plate opposite to said grooved face,
during the attachment step b), said grooved face is in contact with the sacrificial layer (13),
during the separation step c), the plate is thinned via the face opposite said grooved face, at least until the grooves are reached.

8. Process according to any one of claims 1 to 7, wherein the sacrificial layer (3; 13) comprises at least 70% by mass of crude polymers.

9. Process according to claim 8, wherein said crude polymers consist of more than 70% by mass of polypropylene carbonate molecules, other polycarbonate molecules and/or polynorbornene molecules.

10. Process according to any one of claims 1 to 9, wherein the plate (1; 11) is obtained from a wafer essentially comprising silicon Si, germanium Ge, gallium arsenide GaAs, indium arsenide InAs, indium phosphide InP, gallium phosphide GaP, gallium antimonide GaSb, indium antimonide InSb, silicon carbide SiC, gallium nitride GaN, aluminium nitride AlN, and/or diamond.

11. Process according to any one of claims 1 to 10, wherein the sacrificial layer (3; 13) has a transformation temperature to the gaseous state at 100 kPa of between 80°C and 600°C, advantageously between 230°C and 350°C.

12. Process according to any one of claims 1 to 11, wherein the attachment of the plate (1; 11) to the substrate (2; 12) via the sacrificial layer (3; 13) is carried out at a temperature greater than a glass transition temperature of the material or materials of the sacrificial layer.

13. Process according to any one of claims 1 to 12, wherein the plate (1; 11) and the substrate (3; 13) have expansion coefficients that are equal or vary by less than 5%.
